(19) Europäisches Patentamt / European Patent Office / Office européen des brevets

(11) **EP 2 882 101 B1**

(12) **FASCICULE DE BREVET EUROPEEN**

(45) Date de publication et mention
de la délivrance du brevet:
**14.09.2016 Bulletin 2016/37**

(21) Numéro de dépôt: **14195766.2**

(22) Date de dépôt: **02.12.2014**

(51) Int Cl.:
*H03H 9/02* *(2006.01)*
*H03H 7/00* *(2006.01)*
*G01N 29/36* *(2006.01)*
*G01D 5/00* *(2006.01)*
*H01J 49/26* *(2006.01)*
*H03H 9/24* *(2006.01)*
*B81C 99/00* *(2010.01)*
*G01N 27/00* *(2006.01)*
*G01G 3/00* *(2006.01)*
*G01H 11/00* *(2006.01)*

(54) **Procédé de détection d'une perturbation par cycle hystérétique utilisant un résonateur électromécanique non linéaire et dispositif utilisant le procédé**

Verfahren zum Erfassen einer Störung durch einen Hysteresezyklus mit Hilfe eines nicht-linearen elektromechanischen Resonators, und Vorrichtung, die dieses Verfahren anwendet

Method for detecting a disturbance by hysteretic cycle using a non-linear electromechanical resonator and device using the method

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.12.2013 FR 1361972**

(43) Date de publication de la demande:
**10.06.2015 Bulletin 2015/24**

(73) Titulaires:
- **COMMISSARIAT A L'ENERGIE ATOMIQUE ET AUX
  ENERGIES ALTERNATIVES
  75015 Paris (FR)**
- **Ecole Nationale Travaux Publics de l'Etat
  69518 Vaulx-en-Velin Cedex (FR)**
- **Institut National des Sciences Appliquées de Lyon
  69621 Villeurbanne Cedex (FR)**
- **Centre National de la Recherche Scientifique
  75016 Paris (FR)**

(72) Inventeurs:
- **Hentz, Sébastien
  38760 VARCES ALLIERES ET RISSET (FR)**
- **Baguet, Sébastien
  69100 VILLEURBANNE (FR)**
- **Dufour, Régis
  69003 LYON (FR)**
- **Lamarque, Claude-Henri
  42320 FARNAY (FR)**
- **Nguyen, Van Nghi
  Ha Noi (VN)**

(74) Mandataire: **Esselin, Sophie et al
Marks & Clerk France
Conseils en Propriété Industrielle
Immeuble Visium
22 Avenue Aristide Briand
94117 Arcueil Cedex (FR)**

(56) Documents cités:
**WO-A1-02/093111          WO-A1-2010/139055
DE-A1-102005 010 498**

- **VIJAY KUMAR ET AL: "Modeling, Analysis, and Experimental Validation of a Bifurcation-Based Microsensor", JOURNAL OF MICROELECTROMECHANICAL SYSTEMS, IEEE SERVICE CENTER, US, vol. 21, no. 3, 1 juin 2012 (2012-06-01), pages 549-558, XP011445756, ISSN: 1057-7157, DOI: 10.1109/JMEMS.2011.2182502**

EP 2 882 101 B1

**Description**

Le domaine de l'invention est celui des microsystèmes, dénommés MEMS pour MicroElectroMechanicalSystems et plus précisément celui des résonateurs MEMS, présentant une partie mobile pouvant être soumise à vibrations, pour des applications telles que des capteurs inertiels, des capteurs de pression, des capteurs de gaz ou de masse. Par extension, on peut parler de dispositifs MEMS/NEMS pour des dispositifs pouvant présenter certaines de leurs dimensions inférieures au micron, voire de l'ordre du nanomètre.

De manière générale, un capteur résonant est caractérisé par une fréquence de résonance qui dépend principalement de la masse de la partie mobile du capteur, des paramètres géométriques des parties mécaniques du capteur et des paramètres physiques des matériaux formant les différentes parties du capteur, ainsi que du facteur de qualité dépendant des pertes énergétiques du capteur résonant. La dépendance de la fréquence de résonance aux paramètres physiques pré-cités, permet par là-même de réaliser une mesure d'une perturbation extérieure de l'un de ces paramètres (par exemple une variation de masse, une accélération, une pression, ...).

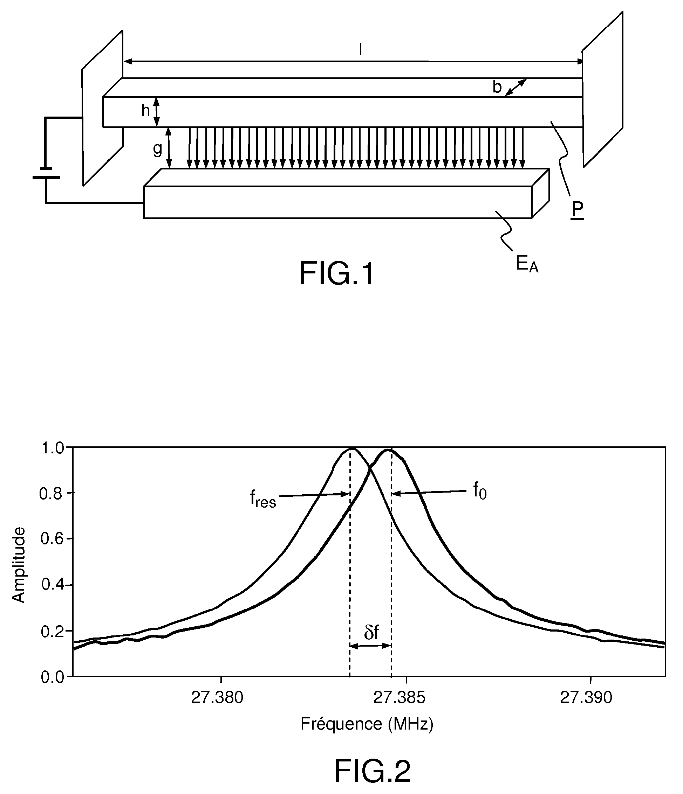

Ainsi dans ce type d'applications, un élément mécanique résonant, pouvant par exemple être une nano-poutre encastrée-encastrée, ou encastrée libre, est équipée classiquement d'au moins une électrode pour l'actionnement $E_A$ permettant d'appliquer une tension de commande, tel qu'illustré en figure 1 et qui représente une poutre encastrée P.

L'effort électrostatique généré par la tension de commande s'écrit alors

$$F_{act} = \frac{1}{2} \varepsilon_0 S \frac{V^2}{(g-x)^2}$$

où S est la surface en regard, g le gap entre l'électrode de commande et la poutre, V la tension d'actionnement comprenant une composante continue et une composante alternative telles que : $V = Vdc + Vac.Cos\Omega t$. La tension continue Vdc fléchit statiquement la poutre alors que la tension harmonique $Vac.Cos\Omega t$ la fléchit dynamiquement.

Classiquement il s'agit de faire vibrer le résonateur sur sa fréquence fondamentale de flexion pour obtenir le maximum d'amplitude. Grâce à une transduction électrique inverse, il est alors possible de déterminer la fréquence de résonance du dispositif à partir de la lecture du signal.

Dans le cas par exemple d'un capteur de masse pouvant être celui schématisé en figure 1. Sous l'effet d'une masse ajoutée ou d'une charge axiale, la fréquence de résonance se décale de la fréquence $f_0$, vers la fréquence $f_{res}$, comme illustré en figure 2. La mesure du décalage fréquentiel $\delta f$ est égal à $f_0 - f_{res}$ avec une fréquence de résonance mesurée $f_{res}$, après détection pouvant être de type capacitif.

De manière classique, l'amplitude d'actionnement du résonateur est maintenue en deçà d'une amplitude dite critique, au-delà de laquelle le régime de vibration devient non linéaire.

Néanmoins, pour améliorer les performances d'un résonateur, il est possible de chercher à obtenir l'amplitude d'actionnement du résonateur la plus grande possible. L'amplitude dépasse alors une valeur seuil correspondant à l'amplitude critique au-delà de laquelle le régime de vibration devient non-linéaire, provoquant l'apparition de phénomènes d'hystérésis. L'apparition de ce régime non-linéaire est notamment décrit dans l'article de N. Kacem, S. Hentz, D. Pinto, B. Reig, and V. Nguyen, "Nonlinear dynamics of nanomechanical beam resonators: improving the performance of NEMS-based sensors," Nanotechnology, vol. 20, p. 275501, 2009 ou dans la dans la demande de brevet EP 2 365 282.

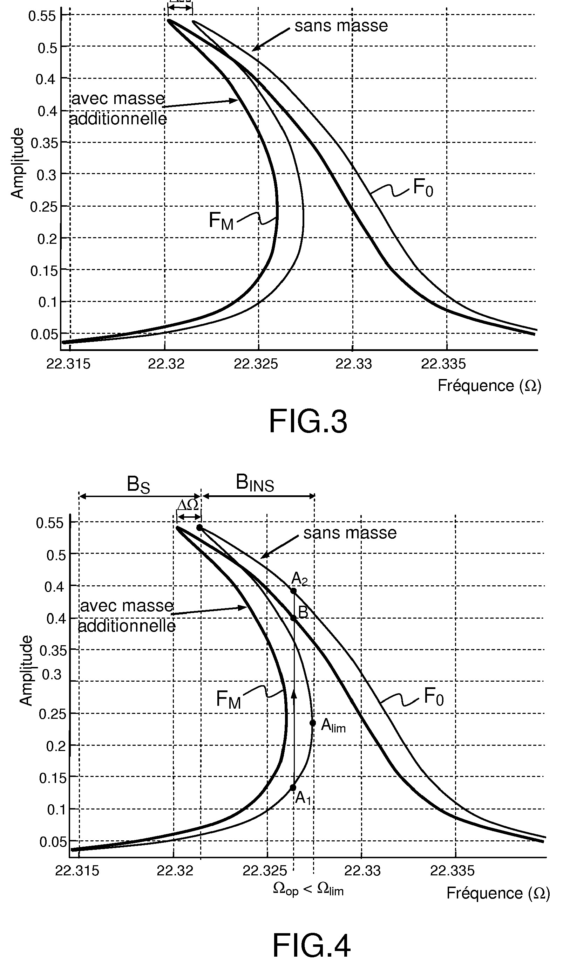

La figure 3 illustre ce principe, dans le cadre de la réponse en fréquence d'un nano-résonateur de type poutre avec un dispositif non-linéaire dit assouplissant (le pic est dévié vers les fréquences basses). Le principe serait identique avec une réponse parfaitement linéaire ou non-linéaire d'un dispositif dit raidissant (pic dévié vers la droite). En l'absence, par exemple, de masse supplémentaire à détecter, la réponse du nano-résonateur en fonction de la fréquence pour des valeurs d'amplitude au-delà du seuil de linéarité, a le comportement de la courbe de réponse initiale $F_0$.

Sous l'effet d'une très faible masse ajoutée, la courbe de réponse du nano-résonateur se décale vers les basses fréquences pour donner la courbe $F_M$. Les mesures fréquentielles classiques consistent à détecter ce décalage $\Delta\Omega$ et à le mesurer. Toutefois, ce décalage devient très faible et difficile à distinguer du bruit de mesure pour de très petites masses.

Il est théoriquement possible d'améliorer la sensibilité en fréquence en diminuant les tailles et/ou en augmentant le rapport signal sur bruit, c'est-à-dire en actionnant de manière plus importante les résonateurs. Toutefois, dans ces conditions, les nano-résonateurs ont un comportement très fortement non-linéaire, source d'instabilités et de mixage de bruit basses et hautes fréquences susceptibles de dégrader la fiabilité et la précision des mesures par décalage fréquentiel comme décrit dans l'article de V. Kaajakari, J. K. Koskinen, and T. Mattila, « Phase noise in capacitively coupled micromechanical oscillators., » IEEE transactions on ultrasonics, ferroelectrics, and frequency control, vol. 52, no. 12, pp. 2322-31, Dec. 2005.

Une autre voie pour améliorer la sensibilité des capteurs résonants consiste à définir des principes de détection alternatifs basés sur l'exploitation des phénomènes non-linéaires. Plusieurs travaux ont déjà été décrits dans la littérature, qui cherchent par exemple à amplifier l'amplitude de réponse du résonateur au moyen de résonances internes ou paramétriques et notamment dans les articles de : W. Zhang and K. L. Turner, "Application of parametric resonance amplification in a single-crystal silicon micro-oscillator based mass sensor," Sensors and Actuators A: Physical, vol. 122, no. 1, pp. 23-30, Jul. 2005 ou de M. 1. Younis and F. Alsaleem, "Exploration of New Concepts for Structures Based on Nonlinear Phenomena," Journal Of Computational And Nonlinear Dynamics, vol. 4(2), 021010, 2009. Mais ces résonances n'existent que lorsque les résonateurs ont des géométries et des excitations bien particulières.

Une alternative également divulguée dans le domaine, consiste à utiliser les sauts en amplitude au voisinage de points de fonctionnement singuliers et est illustrée grâce à la figure 4. Plus précisément, il s'agit de faire vibrer le résonateur sans masse additionnelle à une fréquence fixe $\Omega_{op}$ légèrement inférieure à celle du point limite $A_{lim}$ de la courbe de réponse $F_0$ (sans perturbation). Plus précisément, ce point $A_{lim}$ correspond à un point de bifurcation, correspondant à un changement de croissance et de décroissance de la fréquence.

L'allure de cette courbe de réponse est caractéristique d'un comportement non-linéaire et, à la fréquence d'excitation choisie $\Omega_{op}$, elle possède deux points de fonctionnement stables $A_1$ et $A_2$.

La figure 4 met ainsi en évidence une bande de fréquence dite instable $B_{INS}$ dans laquelle, deux amplitudes stables, peuvent correspondre à une seule fréquence : par exemple les amplitudes A1 et A2 à la fréquence $\Omega_{op}$, alors qu'en deçà d'une certaine valeur de fréquence, on peut définir une bande de fréquence dite stable $B_s$ dans laquelle, il y a bien correspondance entre une fréquence et une seule amplitude stable.

Dans cette configuration, lorsqu'une masse est ajoutée sur le résonateur, la courbe de réponse se décale vers la courbe $F_M$. Etant donné que cette nouvelle courbe de réponse avec masse ajoutée ne possède qu'un seul point de fonctionnement B à la fréquence $\Omega_{op}$, on assiste à un brusque saut en amplitude de $A_1$ vers B , comme décrit dans l'article de V. Kumar, S. Member, Y. Yang, S. Member, G. T. Chiu, and J. F. Rhoads, "Modeling , Analysis , and Experimental Validation of a Bifurcation-Based Microsensor," Journal of Microelectromechanical Systems, vol. 21, no. 3, pp. 549-558, 2012.

Contrairement à la détection fréquentielle basée sur $\Delta\Omega$, ce saut est d'autant plus grand que la masse additionnelle est petite, ce qui rend cette technique particulièrement intéressante. De plus, le seuil de détection en masse peut être ajusté avec la valeur de la fréquence $\Omega_{op}$. On peut ainsi quantifier la masse déposée grâce à l'amplitude du saut en amplitude, mais aussi simplement détecter la présence ou non de la masse, et compter le nombre de particules qui se sont déposées.

Néanmoins, une fois la détection de masse opérée, la nano-poutre libre de particule doit être en mesure de retrouver son état initial, c'est-à-dire retrouver l'état A1. Dans le cas contraire, si au lieu de redescendre sur son point de fonctionnement A1, la nano-poutre saute de son état B à l'état A2, il devient dans ce cas, difficile de détecter à nouveau une variation d'amplitude significative. Une phase de réinitialisation devient nécessaire pour réaliser de nouvelles mesures sensibles.

Dans ce contexte et pour résoudre le problème précité, la présente invention a pour objet un procédé de détection d'une perturbation par cycle hystérétique comprenant au moins un résonateur électromécanique à comportement non linéaire et des moyens d'actionnement et de détection du signal de réception via un transducteur pour analyser le signal de réponse.

Plus précisément la présente invention a pour objet un procédé de détection d'une perturbation par rapport à un état initial selon la revendication 1.

Selon une variante de l'invention, ladite fréquence de vibration varie autour d'une fréquence centrale $\Omega_{op}$ selon la loi : $\Omega(t) = \Omega_{op} + \delta\Omega \cos(\varepsilon \pi t + \varphi)$ avec $\varepsilon$ la vitesse de balayage en fréquence, $\varphi$ ayant une valeur comprise entre 0 et $2\pi$.

La fréquence de vibration peut bien sûr varier selon tout type de loi, comme par exemple une loi carrée, que l'on peut décrire sous forme d'une série infinie : $\Omega(t) = \Omega_{op} + \delta\Omega \cdot \dfrac{4}{\pi} \sum_{n=0}^{\infty} \dfrac{\sin((2n+1)\varepsilon\pi t)}{(2n+1)}$

Selon une variante de l'invention, la fréquence maximale $Q_{max}$ est telle que le facteur en valeur absolue $|\Omega_{lim} - \Omega_{max}|$ est compris entre 0 et $10^{-1}$ fois $\Omega_{op}$ et avantageusement entre $10^{-9}$ fois $\Omega_{op}$ et 10 fois $\Omega_{op}$.

Selon une variante de l'invention, le procédé comprend une étape de traitement permettant de recaler dans le temps selon la revendication 4.

Selon une variante de l'invention, le paramètre physique est la masse, les fréquences $\Omega_{min}$ et $\Omega_{max}$ déterminant les seuils de la plus grande masse et de la plus petite masse à détecter.

Selon une variante de l'invention, la vitesse de balayage en fréquence $\varepsilon$ d'un cycle est comprise entre environ 1 Hz et 100 kHz ou avec un ratio $\varepsilon\pi/\Omega_{op}$ tel que $0 < \varepsilon\pi/\Omega_{op} < 10^{-1}$.

L'invention a aussi pour objet un dispositif de détection d'une perturbation par rapport à un état initial selon la revendication 7.

Selon une variante de l'invention, ladite source d'excitation comprend des moyens piézoélectriques ou thermoélastiques ou magnétiques ou électrostatiques ou optiques.

Selon une variante de l'invention, lesdits moyens de détection comprennent au moins un transducteur de type piézorésistif ou capacitif ou piézoélectrique ou optique ou magnétique.

Selon une variante de l'invention, l'élément mécanique résonant est un résonateur de type poutre, la source d'excitation comprenant une électrode d'actionnement en regard dudit résonateur.

Selon une variante de l'invention, le résonateur est un résonateur de type poutre de dimensions nanométriques, l'électrode de commande permettant d'appliquer des tensions de l'ordre de quelques Volts, le gap entre ladite électrode de commande et ledit résonateur étant de l'ordre de quelques centaines de nm, et par exemple entre 10 nm et 1$\mu$m.

L'invention a encore pour objet un capteur de masse comprenant un dispositif selon l'invention.

L'invention a également pour objet un détecteur de gaz ou de particules comprenant un dispositif selon l'invention, permettant la quantification de la concentration des espèces en présence, s'absorbant dans une couche de fonctionnalisation chimique.

L'invention a également pour objet un spectromètre de masse comprenant un dispositif selon l'invention permettant de mesurer la masse de chacune des particules se posant sur ledit dispositif.

L'invention sera mieux comprise et d'autres avantages apparaîtront à la lecture de la description qui va suivre donnée à titre non limitatif et grâce aux figures annexées parmi lesquelles :

- la figure 1 illustre un exemple de mise en vibration d'un élément mécanique vibrant, actionné par une électrode de commande selon l'art connu ;
- la figure 2 illustre le décalage en fréquence de résonance d'un élément vibrant de l'art connu, entre un état initial et un état de mesure après variation de masse ;
- la figure 3 illustre la courbe de réponse en fréquence d'un élément mécanique vibrant, excité dans un régime non-linéaire et stationnaire;
- la figure 4 illustre l'exploitation du régime non-linéaire en termes de variation d'amplitude, entre les courbes de réponse correspondant à un état initial et à un état mesure après variation de masse, dans le cadre d'un résonateur dit assouplissant
- la figure 5 illustre les courbes de réponse générées par la source d'excitation utilisée dans le dispositif de l'invention permettant d'intégrer un processus de réinitialisation de la mesure, dans le cadre d'un résonateur dit assouplissant ;
- les figures 6a, 6b et 6c illustrent le détail des cycles de balayage en fréquence respectivement en absence de détection de particule, en présence de détection de particule ;
- les figures 7a et 7b illustrent les cycles utilisés dans un dispositif selon l'invention, respectivement à des instants différents correspondant au phénomène de désorption ;
- la figure 8 illustre un autre exemple de courbes de réponse générées par la source d'excitation utilisée dans le dispositif de l'invention permettant d'intégrer un processus de réinitialisation de la mesure, dans le cadre d'un résonateur dit raidissant.

Selon la présente invention, le dispositif comprend au moins un élément mécanique résonant, encore dénommé résonateur, et une source d'excitation capable d'amener ledit résonateur dans son domaine de fonctionnement non-linéaire en actionnement avec une amplitude adéquate et ce quelles qu'en soient les dimensions et le principe de transduction.

Ce peut être par exemple un dispositif à actionnement piézoélectrique, thermoélastique, magnétique, électrostatique ou encore optique, et à détection piézorésistive, capacitive, piézoélectrique, optique ou magnétique, selon l'art connu.

Avantageusement, le résonateur peut être un résonateur de type poutre en silicium, de dimensions nanométriques, par exemple quelques $\mu$m de long, quelques 100nm d'épaisseur et de largeur, résonant à des fréquences de l'ordre de la dizaine de MHz.

Avantageusement le résonateur peut être un résonateur dont on sait contrôler le coefficient de non-linéarité pour le rendre assouplissant : la courbe retraçant l'amplitude fonction de la fréquence de résonance étant orientée vers les fréquences basses par rapport à une droite perpendiculaire à l'axe des abscisses, ou raidissant : la courbe retraçant l'amplitude fonction de la fréquence de résonance étant orientée vers les fréquences hautes par rapport à une droite perpendiculaire à l'axe des abscisses. On peut notamment utiliser pour ce faire une électrode électrostatique à proximité comme décrit dans la référence de Kacem et al, "Nonlinear dynamics of nanomechanical beam resonators: improving the performance of NEMS-based sensors," Nanotechnology, vol. 20, p. 275501, 2009 ou dans la demande de brevet EP 2 365 282, par exemple avec un gap de l'ordre de 100nm. Les tensions utilisées peuvent atteindre quelques Volts, ac ou dc.

Celles-ci sont ajustées en fonction du dispositif, par exemple pour obtenir une amplitude de vibration entre 1 fois l'amplitude critique et 10 fois celle-ci, comme décrit dans l'article de N. Kacem, S.Hentz, D.Pinto, B.Reig and V.Nguyen « Nonlinear dynamics of nanomechanical beam resonators: improving the performance of NEMS-based sensors » Nanotechnology, vol. 20, p. 275501, 2009.

La présente invention est décrite ci-après dans le cadre d'une perturbation correspondant à une détection de masse, typiquement de particules mais peut être appliquée plus largement à toute détection de perturbation engendrant une variation de fréquence de résonance de l'élément vibrant excité selon les moyens décrits dans la présente invention et illustrée ci-après dans le cadre d'un résonateur assouplissant.

Ainsi en se référant à la figure 4 précédemment explicitée, lors d'une détection d'une perturbation en l'occurrence une masse supplémentaire décalant la fréquence de résonance sur la courbe $F_M$, si la réponse se stabilise à l'état B avec la masse ajoutée, au départ de celle-ci, la réponse rejoint ou bien l'état $A_1$ ou bien l'état $A_2$ :

- s'il s'agit de l'état $A_1$, la variation de masse suivante peut être détectée aisément ;
- si au contraire, le passage s'opère de l'état B à l'état $A_2$, la masse ajoutée suivante à détecter génère un saut de petite amplitude, difficile à mesurer précisément.

Pour pallier ce problème, la présente invention propose un dispositif comprenant des moyens d'actionnement intégrant une phase de réinitialisation de mesure permettant de ne pas se retrouver dans la position figée correspondante à l'état A2, et permettant ou forçant un retour à l'état A1 dans tous les cas de figures.

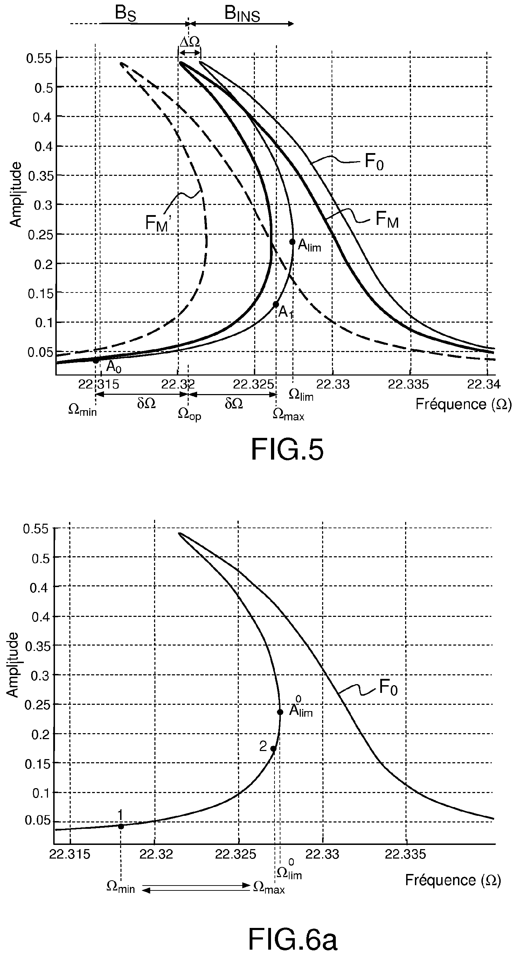

Les moyens d'actionnement de la présente invention sont tels qu'ils permettent de réaliser le cycle de balayage en fréquence illustré en figure 5, en temps dit « lent » par rapport à la période associée à $\Omega_{op}$ de telle sorte que $0 < \varepsilon\pi/\Omega_{op} < 10^{-1}$, et ce dans une gamme de fréquences bien définies entre une borne de fréquence minimale $\Omega_{min}$ et une borne de fréquence maximale $\Omega_{max}$, telle que ladite fréquence maximale appartienne à la plage de fréquences instables $B_{ins}$ (deux amplitudes stables possibles pour une même fréquence), ladite fréquence minimale appartenant à la plage de fréquences stables $B_s$ (une seule amplitude possible pour une même fréquence), l'intérêt des deux amplitudes possibles respectivement inférieure et supérieure à l'amplitude $A_{lim}$ permettant comme illustré sur les figures 4 et 5, la détection d'une variation importante d'amplitude, la courbe $F_M'$ étant relative à une autre masse ajoutée.

La figure 6a illustre plus précisément, le cycle suivi en l'absence de particule. On parcourt la courbe $F_0$ entre les points 1 et 2, il n'y a pas de cycle d'hystérésis ni de saut d'amplitude associé.

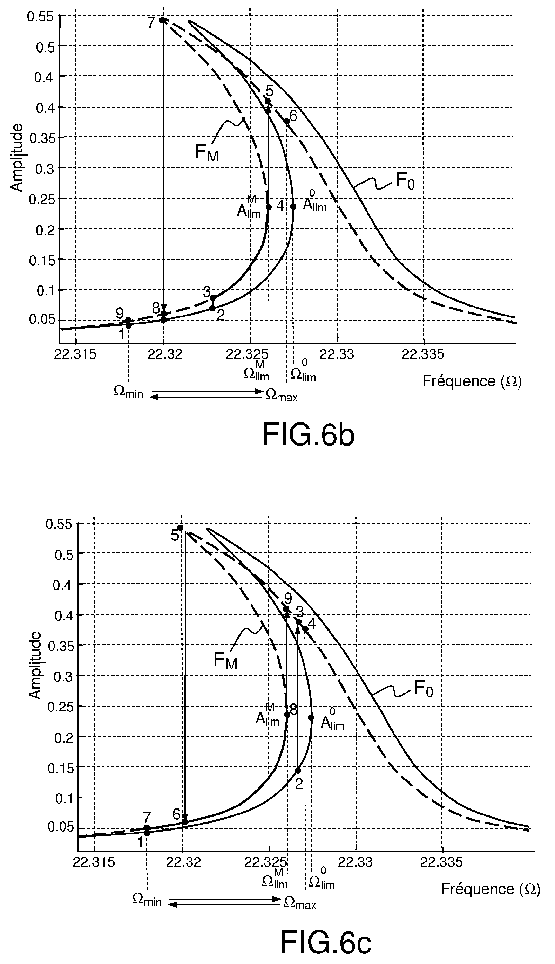

Lors de la détection d'une première variation de masse, en faisant varier la fréquence, on décrit les cycles décrits sur les figures 6b et 6c, suivant l'instant de l'évènement.

Plus précisément, avec la détection d'une particule :

Dans le premier cas, illustré en figure 6b, où la particule tombe à un instant (point 2) tel que la fréquence de balayage se situe avant $\Omega_{lim}^M$ : on parcourt alors le cycle d'hystérésis selon les chemins reliés par la succession des points suivants : 1-2-3 / 4-5-6-7-8-9 / 4-5-6-7-8-9 / ..., on observe un grand saut d'amplitude de 4 à 5 de manière cyclique.

Dans le second cas, illustré par la figure 6c, où la particule tombe à un instant (point 2) tel que la fréquence de balayage se situe entre $\Omega_{lim}^M$ et $\Omega_{lim}^0$: on parcourt alors le cycle d'hystérésis selon les chemins reliés par la succession des points suivants : 1-2-3 / 4-5-6-7-8-9 / 4-5-6-7-8-9 / ..., on observe un grand saut d'amplitude de 2 à 3 une seule fois puis de 8 à 9 de manière cyclique.

Dans le cas d'une désorption de la molécule détectée au niveau du résonateur (par exemple pour une particule de gaz avec faible énergie de liaison), correspondant au retour à un état initial, on souhaite pouvoir repositionner la situation à un état situé entre les points $A_1$ et $A_2$ appartenant à la courbe $F_0$.

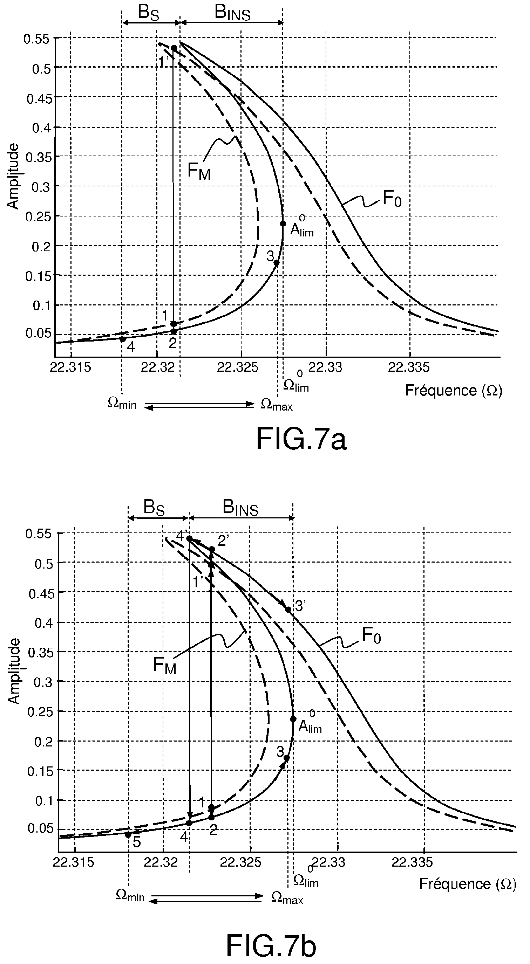

Lors de la désorption de la particule, en faisant varier la fréquence, on décrit les cycles décrits sur les figures 7a et 7b, suivant l'instant de l'évènement.

Dans le premier cas, illustré en figure 7a, où la particule décolle à un instant (point 2) tel que la fréquence de balayage se situe dans la plage de fréquences stables $B_s$ (une seule amplitude stable possible pour une même fréquence) : on part du point 1 ou 1' selon qu'on se situe en haut ou en bas de la courbe $F_M$ et on parcourt alors le cycle selon les chemins reliés par la succession des points suivants : 1 ou 1'-2-3 / 4-3 / 4-3 / ... Après un saut vers le point 2 une seule fois, on parcourt la courbe $F_0$ entre les points 3 et 4, il n'y a pas de cycle d'hystérésis ni de saut d'amplitude associé.

Dans le second cas, illustré par la figure 7b, où la particule décolle à un instant (point 2) tel que la fréquence de balayage se situe dans la plage de fréquences instables $B_{IN}s$ (deux amplitudes stables possibles pour une même fréquence) : on part du point 1 ou 1' selon qu'on se situe en haut ou en bas de la courbe $F_M$ et on saute soit vers le point 2 en bas de la courbe $F_0$ soit vers le point 2' en haut de la courbe $F_0$. Si on saute vers le point 2, on parcourt alors le cycle selon les chemins reliés par la succession des points suivants : 1 ou 1'-2-3 / 3-5 / 3-5 / ... Après un saut vers le point 2 une seule fois, on parcourt la courbe $F_0$ entre les points 3 et 5, il n'y a pas de cycle d'hystérésis ni de saut d'amplitude associé. Si on saute vers le point 2', on parcourt alors le cycle selon les chemins reliés par la succession des points suivants : 1 ou 1'-2'-3'-4'-4-5 / 3-5 / 3-5 / ... Après un saut vers le point 2' et un saut vers le point 4 une seule fois, on parcourt la courbe $F_0$ entre les points 3 et 5, il n'y a pas de cycle d'hystérésis ni de saut d'amplitude associé.

Dans le cas, où le capteur de masse ne désorbe pas, les particules détectées, restant présentes, il est possible de continuer avantageusement le processus d'interrogation selon la présente invention. En effet, la figure 5 met en évidence une troisième courbe en traits pointillés $F_M$', correspondant à la courbe obtenue lors d'une seconde mesure, la courbe $F_M$ devenant la nouvelle courbe de référence.

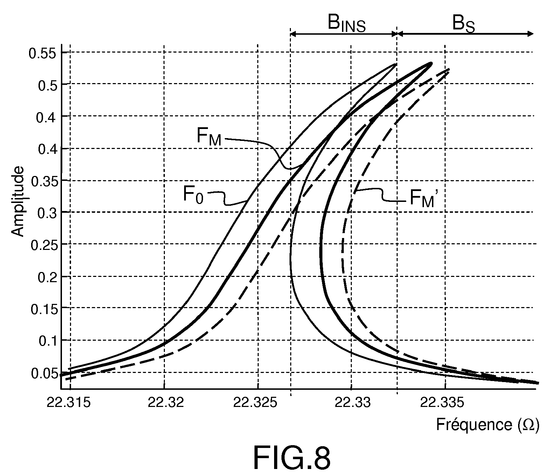

La figure 8 montre le même type de balayage en fréquences, utilisé dans la présente invention, dans le cadre d'un résonateur raidissant, avec des fréquences de résonance qui varient de manière croissante, lors de la détection d'une perturbation.

Avantageusement, la fréquence d'actionnement variant dans la gamme de fréquences [$\Omega_{mim}$ ; $\Omega_{max}$], peut varier périodiquement autour d'une fréquence centrale $\Omega_{op}$ prédéterminée, les fréquences $\Omega_{min}$ et $\Omega_{max}$ étant réglées comme dans le descriptif de la figure 5.

On considère ainsi que la fréquence varie selon l'équation suivante :

$$\Omega(t) = \Omega_{op} + \delta\Omega \, Cos \, (\varepsilon \, \pi \, t + \varphi) \text{ avec } \varepsilon \text{ tel que } 0 < \varepsilon\pi/\Omega_{op} < 10^{-1}$$

avec $\varepsilon$ tel que $0 < \varepsilon\pi/\Omega_{op} < 10^{-1}$ avec $\varepsilon$ la vitesse de balayage en fréquence.

On module ainsi de manière harmonique la fréquence d'excitation autour d'une valeur de fréquence $\Omega_{op}$ avec une amplitude de modulation $\delta\Omega$, dans la gamme de fréquence [$\Omega_{min}$ ; $\Omega_{max}$].

Il est bien entendu qu'on peut faire varier cette fréquence selon tout type de loi, comme par exemple une loi carrée, que l'on peut décrire sous forme d'une série infinie : $\Omega(t) = \Omega_{op} + \delta\Omega.\frac{4}{\pi}\sum_{n=0}^{\infty}\frac{sin((2n+1)\varepsilon\pi t)}{(2n+1)}$.

Dans le cas du résonateur avant détection de particules, on peut définir une fréquence de bifurcation $\Omega_{lim}$.

Cette dernière peut être déterminée expérimentalement en observant la réponse en fréquence du dispositif. On choisit alors une fréquence $\Omega_{max}$ légèrement inférieure à cette valeur, qui calibre la plus petite masse qu'il est possible de détecter, par exemple |$\Omega_{min}$ - $\Omega_{max}$| compris entre 0 et $10^{-1}$ fois la fréquence $\Omega_{op}$, avantageusement entre $10^{-9}$ et $10^{-1}$ fois la fréquence $\Omega_{op}$.

On définit alors l'amplitude de modulation $\delta\Omega$ et la valeur $\Omega$ op par rapport à la plus grosse particule à détecter.

En effet la fréquence minimale $\Omega_{min} = \Omega_{max}$ - 2 $\delta\Omega$ atteinte par modulation doit se situer dans une zone de fréquence où un seul état vibratoire est possible (quasi-linéaire).

Toutes les courbes de réponses de la poutre avec ou sans particule présentent la même allure (pic dévié vers les basses fréquences), d'autant plus décalée à gauche que la masse ajoutée est forte.

En effet, il peut être particulièrement avantageux de prévoir une gamme de fréquences, telles que différents types de particules de masse différentes puissent être détectés. Ainsi dans le cadre de la détection par exemple d'un ensemble de type de particules de masse spécifique distinctes et croissantes, il existe un type de particules à détecter ayant une masse maximale et donc une courbe spécifique, appelée courbe limite, maximisant le décalage vers la gauche.

Ensuite, le calibrage de la vitesse de balayage $\varepsilon$ s'effectue en respectant le principe suivant : le balayage doit être assez rapide pour que durant la présence d'une particule sur la poutre comme décrit dans l'article de Chaste et al, « A nanomechanical mass sensor with yoctogram resolution », Nature Nanotechnology 2012, au moins un cycle complet de balayage de l'intervalle de modulation [$\Omega_{max}$ - 2 $\delta\Omega$, $\Omega_{max}$] puisse être réalisé.

Cette fréquence de balayage $\varepsilon$ peut être comprise entre par exemple 1 Hz et 100kHz ou réglée telle que 0 < $\varepsilon\pi/\Omega_{op}$ < $10^{-1}$. Le principe de modulation de fréquence est connu dans le domaine des dispositifs RF, et peut être implanté par nombre de sources de tensions RF commerciales, et est également utilisé comme principe de détection du mouvement mécanique d'un NEMS comme décrit dans l'article de V. Gouttenoire, T. Barois, S. Perisanu, J.-L. Leclercq, S. T. Purcell, P. Vincent, and A. Ayari, "Digital and FM demodulation of a doubly clamped single-walled carbon-nanotube oscillator: towards a nanotube cell phone.," Small (Weinheim an der Bergstrasse, Germany), vol. 6, no. 9, pp. 1060-5, May 2010.

Il est ainsi possible de réaliser la transduction du mouvement mécanique du dispositif en même temps que l'on applique le principe de détection.

Au cours de mesures continues, et avec un état du résonateur qui ne revient pas à son état initial, les perturbations s'accumulant, une courbe $F_M$ devient une courbe initiale pour la courbe de mesure suivante $F_M$' et ainsi de proche en proche. Il peut être intéressant dans ce type de cas de figures, de vérifier que la nouvelle courbe d'état initial $F_M$ permet de maintenir les conditions requises au niveau des bornes de fréquences dans la présente invention à savoir, que l'une de ces bornes appartient à la bande de fréquences instables et l'autre à la bande de fréquences stables, permettant le cas échéant de recaler la fréquence centrale $\Omega_{op}$.

Pour assurer ce contrôle, les moyens de détection et d'analyse du signal issu du transducteur électrique de détection peuvent avantageusement être corrélés à la source d'excitation dans une boucle d'asservissement, lorsqu'il est détecté que la fréquence $\Omega_{min}$ n'est plus assez basse et ne permet plus de sauter de la branche supérieure à la branche inférieure (voir points 7 à 8 de la figure 6b), les fréquences $\Omega_{min}$ et $\Omega_{max}$ déterminant les seuils de la plus grande et de la plus petite masse à détecter.

L'invention étant générique, elle peut s'appliquer à un grand nombre de dispositifs, utilisant par exemple des NEMS silicium tels que décrits dans l'article E. Mile, G. Jourdan, I. Bargatin, S. Labarthe, C. Marcoux, P. Andreucci, S. Hentz, C. Kharrat, E. Colinet, and L. Duraffourg, "In-plane nanoelectromechanical resonators based on silicon nanowire piezoresistive detection.," Nanotechnology, vol. 21, no. 16, p. 165504, Apr. 2010, ou dans la demande de brevet déposée par le Demandeur: PCT/EP2011/065682.

**Revendications**

1.  Procédé de détection d'une perturbation par rapport à un état initial, d'un dispositif comprenant au moins un élément mécanique résonant présentant un paramètre physique sensible à une perturbation telle que ladite perturbation modifie la fréquence de résonance dudit élément mécanique résonant, ledit procédé comprenant :

    - l'excitation de l'élément mécanique résonant permettant de faire vibrer ledit élément mécanique résonant dans un domaine de réponse non-linéaire en amplitude à une fréquence de vibration variable, ladite amplitude et ladite fréquence étant reliée par une fonction initiale, ladite perturbation générant une fonction de mesure ;
    - la détection et l'analyse des variations d'amplitude de vibrations dudit élément mécanique entre une amplitude de la fonction initiale et une amplitude de la fonction de mesure résultant de l'excitation, **caractérisé en ce que** ladite fonction initiale présente une fréquence dite de bifurcation $\Omega_{lim}$, correspondant à un changement de croissance et de décroissance de la fréquence en fonction de l'amplitude et possède au moins une bande de fréquences instables ($B_{INS}$) dans laquelle il existe au moins deux amplitudes stables pour une même fréquence, et au moins une bande de fréquence stable ($B_S$) dans laquelle une seule amplitude stable correspond à une seule fréquence, l'étape d'excitation de l'élément mécanique résonant étant réalisée comprenant:

       - faire vibrer l'élément mécanique à la fréquence de vibration variable dans une bande de fréquence définie par une fréquence minimale ($\Omega_{min}$) et une fréquence maximale ($\Omega_{max}$) et
       - selon au moins un cycle de fréquence centré sur une fréquence centrale $\Omega_{op}$, l'une desdites fréquences minimale ou maximale étant située dans la bande de fréquences stables de ladite fonction initiale, l'autre fréquence maximale ou minimale étant située dans la bande de fréquences instables.

2.  Procédé de détection d'une perturbation par rapport à un état initial selon la revendication 1, **caractérisé en ce que** ladite fréquence de vibration variable varie autour d'une fréquence centrale $\Omega_{op}$ selon la loi : $\Omega(t) = \Omega_{op} + \delta\Omega$ Cos ($\varepsilon \pi t + \varphi$) avec $\varepsilon$ la vitesse de balayage en fréquence, $\varphi$ ayant une valeur comprise entre 0 et $2\pi$, et étant la fréquence de vibration variable.

3.  Procédé de détection d'une perturbation par rapport à un état initial selon l'une des revendications 1 ou 2, **caractérisé en ce que** la fréquence maximale $\Omega_{max}$ est telle que le facteur en valeur absolue :

    $|\Omega_{min} - \Omega_{max})|$ est compris entre 0 et $10^{-1} \Omega_{op}$.

4.  Procédé de détection d'une perturbation par rapport à un état initial selon l'une des revendications 1 à 3, **caractérisé en ce qu'**il comprend une étape de traitement permettant de recaler dans le temps, ladite fréquence centrale $\Omega_{op}$ de manière à ce que ladite fréquence centrale appartienne à la bande de fréquences définie par la fréquence minimale et maximale.

5.  Procédé de détection d'une perturbation par rapport à un état initial selon l'une des revendications 1 à 4, **caractérisé en ce que** le paramètre physique est la masse, les fréquences minimale et maximale déterminant les seuils de la plus grande masse et de la plus petite masse à détecter.

6.  Procédé de détection d'une perturbation par rapport à un état initial selon l'une des revendications 1 à 5, **caractérisé en ce que** la vitesse de balayage en fréquence $\varepsilon$ d'un cycle est comprise entre environ 1 Hz et 100 kHz ou avec un ratio $\varepsilon\pi/\Omega_{op}$ tel que $0 < \varepsilon\pi/\Omega_{op} < 10^{-1}$.

7.  Dispositif de détection d'une perturbation par rapport à un état initial, comprenant :

    - au moins un élément mécanique résonant (P) présentant un paramètre physique sensible à une perturbation telle que ladite perturbation modifie la fréquence de résonance dudit élément mécanique résonant;

- une source d'excitation de l'élément mécanique résonant permettant faire vibrer ledit élément mécanique résonant dans un domaine de réponse non-linéaire en amplitude à une fréquence de vibration variable, ladite amplitude et ladite fréquence étant reliée par une fonction initiale, ladite perturbation générant une fonction de mesure ;
- des moyens de détection et d'analyse des variations d'amplitude de vibrations dudit élément mécanique entre une amplitude de la fonction initiale et une amplitude de la fonction de mesure, **caractérisé en ce que** :

- ladite fonction initiale présente une fréquence dite de bifurcation $\Omega_{lim}$, correspondant à un changement de croissance et de décroissance de la fréquence en fonction de l'amplitude et possède au moins une bande de fréquences instables ($B_{INS}$) dans laquelle il existe au moins deux amplitudes stables pour une même fréquence, et au moins une bande de fréquence stable ($B_S$) dans laquelle une seule amplitude stable correspond à une seule fréquence ;
- ladite source d'excitation comprend des moyens qui font varier ladite fréquence de vibration dans une bande de fréquence définie par une fréquence minimale et une fréquence maximale et selon au moins un cycle de fréquence centré sur une fréquence centrale $\Omega_{op}$, l'une desdites fréquences minimale ou maximale étant située dans la bande de fréquence stable de ladite fonction initiale, l'autre fréquence maximale ou minimale étant située dans la bande de fréquences instables.

8. Dispositif de détection d'une perturbation par rapport à un état initial, comprenant au moins un élément mécanique résonant présentant un paramètre physique sensible à une perturbation selon la revendication 7, **caractérisé en ce que** ladite source d'excitation comprend des moyens piézoélectriques ou thermoélastiques ou magnétiques ou électrostatiques ou optiques.

9. Dispositif de détection d'une perturbation par rapport à un état initial, comprenant au moins un élément mécanique résonant présentant un paramètre physique sensible à une perturbation selon l'une des revendications 7 ou 8, **caractérisé en ce que** lesdits moyens de détection comprennent au moins un transducteur de type piézorésistif ou capacitif ou piézoélectrique ou optique ou magnétique.

10. Dispositif de détection d'une perturbation par rapport à un état initial, comprenant au moins un élément mécanique résonant présentant un paramètre physique sensible à une perturbation selon l'une des revendications 7 à 9, **caractérisé en ce que** l'élément mécanique résonant est un résonateur de type poutre, (P) la source d'excitation comprenant une électrode d'actionnement ($E_A$) en regard dudit résonateur.

11. Dispositif de détection d'une perturbation par rapport à un état initial, comprenant au moins un élément mécanique résonant présentant un paramètre physique sensible à une perturbation selon la revendication 10, **caractérisé en ce que** le résonateur est un résonateur de type poutre de dimensions nanométriques, l'électrode de commande permettant d'appliquer des tensions de l'ordre de quelques Volts, le gap entre ladite électrode de commande et ledit résonateur étant de l'ordre de quelques centaines de nm, et par exemple entre 10 nm et 1$\mu$m.

12. Capteur de masse comprenant un dispositif selon l'une des revendications 7 à 11.

13. Détecteur de gaz ou de particules comprenant un dispositif selon l'une des revendications 7 à 11 permettant la quantification de la concentration des espèces en présence, s'absorbant dans une couche de fonctionnalisation chimique.

14. Spectromètre de masse comprenant un dispositif selon l'une des revendications 7 à 11 permettant de mesurer la masse de chacune des particules se posant sur ledit dispositif.

**Patentansprüche**

1. Verfahren zum Erkennen einer Störung in Bezug auf einen Anfangszustand eines Geräts, das wenigstens ein mechanisches Resonanzelement mit einem physikalischen Parameter umfasst, der für eine Störung empfindlich ist, so dass die Störung die Resonanzfrequenz des mechanischen Resonanzelements modifiziert, wobei das Verfahren Folgendes beinhaltet:

- Anregen des mechanischen Resonanzelements, so dass das mechanische Resonanzelement in einer nichtlinearen Amplituden-Antwortdomäne mit einer variablen Vibrationsfrequenz vibrieren kann,

- wobei die Amplitude und die Frequenz mit einer Anfangsfunktion verbunden sind, wobei die Störung eine Messfunktion erzeugt;
- Erkennen und Analyiseren von Amplitudenvariationen von Vibrationen des mechanischen Elements zwischen einer Amplitude der Anfangsfunktion und einer Amplitude der von der Anregung resultierenden Messfunktion,

**dadurch gekennzeichnet, dass** die Anfangsfunktion eine Frequenz hat, Verzweigungsfrequenz $\Omega_{lim}$ genannt, die einer Anstiegs- und Abklingänderung der Frequenz in Abhängigkeit von der Amplitude entspricht und wenigstens ein instabiles Frequenzband ($B_{INS}$) hat, in dem wenigstens zwei stabile Amplituden für dieselbe Frequenz existieren, und wenigstens ein stabiles Frequenzband ($B_S$), in dem eine einzige stabile Amplitude einer einzigen Frequenz entspricht, wobei der Schritt des Anregens des mechanischen Resonanzelements wie folgt durchgeführt wird:

- Vibrierenlassen des mechanischen Elements mit der variablen Vibrationsfrequenz in einem Frequenzband, das durch eine Mindestfrequenz ($\Omega_{min}$) und eine Höchstfrequenz ($\Omega_{max}$) definiert wird; und
- gemäß wenigstens einem auf einer Mittenfrequenz $\Omega_{op}$ zentrierten Frequenzzyklus, wobei sich die Mindest- oder die Höchstfrequenz im stabilen Frequenzband der Anfangsfunktion befindet und die jeweils andere aus Höchst- oder Mindestfrequenz sich im instabilen Frequenzband befindet.

2. Verfahren zum Erkennen einer Störung in Bezug auf einen Anfangszustand nach Anspruch 1, **dadurch gekennzeichnet, dass** die variable Vibrationsfrequenz um eine Mittenfrequenz $\Omega_{op}$ gemäß dem folgenden Gesetz variiert: $\Omega(t)= \Omega_{op+}\ \delta\Omega\ Cos\ (\varepsilon\ \pi\ t + \varphi)$, wobei $\varepsilon$ die Frequenzabtastgeschwindigkeit ist, $\varphi$ ein Wert zwischen 0 und $2\pi$ ist und $\Omega$ die variable Vibrationsfrequenz ist.

3. Verfahren zum Erkennen einer Störung in Bezug auf einen Anfangszustand nach Anspruch 1 oder 2, **dadurch gekennzeichnet, dass** die Höchstfrequenz $\Omega_{max}$ derart ist, dass der Faktor als Absolutwert $|\Omega_{lim} - \Omega_{max}|$ zwischen 0 und $10^{-1}\ \Omega_{op}$ liegt.

4. Verfahren zum Erkennen einer Störung in Bezug auf einen Anfangszustand nach einem der Ansprüche 1 bis 3, **dadurch gekennzeichnet, dass** es einen Verarbeitungsschritt beinhaltet, der ein Glätten der Mittenfrequenz $\Omega_{op}$ über die Zeit zulässt, so dass die Mittenfrequenz zu dem durch die Mindest- und die Höchstfrequenz definierten Frequenzband gehört.

5. Verfahren zum Erkennen einer Störung in Bezug auf einen Anfangszustand nach einem der Ansprüche 1 bis 4, **dadurch gekennzeichnet, dass** der physikalische Parameter die Masse ist, wobei die Mindest- und Höchstfrequenz die Schwellen der zu erkennenden größten Masse und kleinsten Masse bestimmen.

6. Verfahren zum Erkennen einer Störung in Bezug auf einen Anfangszustand nach einem der Ansprüche 1 bis 5, **dadurch gekennzeichnet, dass** die Frequenzabtastgeschwindigkeit $\varepsilon$ eines Zyklus zwischen etwa 1 Hz und 100 kHz liegt oder ein solches Verhältnis $\varepsilon\pi/\Omega_{op}$ hat, dass $0 < \varepsilon\pi/\Omega_{op}<10^{-1}$ ist.

7. Vorrichtung zum Erkennen einer Störung in Bezug auf einen Anfangszustand, die Folgendes umfasst:

- wenigstens ein mechanisches Resonanzelement (P) mit einem physikalischen Parameter, der für eine Störung empfindlich ist, so dass die Störung die Resonanzfrequenz des mechanischen Resonanzelements modifiziert;
- eine Quelle zum Anregen des mechanischen Resonanzelements, die es zulässt, das mechanische Resonanzelement in einer nichtlinearen Amplituden-Antwortdomäne mit einer variablen Vibrationsfrequenz vibrieren zu lassen,

wobei die Amplitude und die Frequenz durch eine Anfangsfunktion verbunden sind, wobei die Störung eine Messfunktion erzeugt;

- Mittel zum Erkennen und Analysieren von Amplitudenvariationen von Vibrationen des mechanischen Elements zwischen einer Amplitude der Anfangsfunktion und einer Amplitude der Messfunktion,

**dadurch gekennzeichnet, dass**:

- die Anfangsfunktion eine Frequenz hat, Verzweigungsfrequenz $\Omega_{lim}$ genannt, die einer Anstiegs- und Abklingänderung der Frequenz in Abhängigkeit von der Amplitude entspricht und wenigstens ein instabiles Frequenzband ($B_{INS}$) hat, in dem wenigstens zwei stabile Amplituden für dieselbe Frequenz existieren, und wenigstens ein stabiles Frequenzband ($B_S$), in dem eine einzige stabile Amplitude einer einzigen Frequenz entspricht;
- die Anregungsquelle Mittel zum Variieren der Vibrationsfrequenz in einem durch eine Mindestfrequenz und Höchstfrequenz definierten Frequenzband und gemäß wenigstens einem auf einer Mittenfrequenz $\Omega_{op}$ zentrierten Frequenzzyklus definiert ist, wobei sich die Mindest- oder die Höchstfrequenz im stabilen Frequenzband der Anfangsfunktion befindet, wobei sich die jeweils andere aus Höchst- oder Mindestfrequenz im instabilen Frequenzband befindet.

8. Vorrichtung zum Erkennen einer Störung in Bezug auf einen Anfangszustand, die wenigstens ein mechanisches Resonanzelement mit einem physikalischen Parameter umfasst, der für eine Störung gemäß Anspruch 7 empfindlich ist, **dadurch gekennzeichnet, dass** die Anregungsquelle piezoelektrische oder thermoelastische oder magnetische oder elektrostatische oder optische Mittel umfasst.

9. Vorrichtung zum Erkennen einer Störung in Bezug auf einen Anfangszustand, die wenigstens ein mechanisches Resonanzelement mit einem physikalischen Parameter umfasst, der für eine Störung nach Anspruch 7 oder 8 empfindlich ist, **dadurch gekennzeichnet, dass** das Erkennungsmittel wenigstens einen Wandler des piezoresistiven oder kapazitiven oder piezoelektrischen oder optischen oder magnetischen Typs umfasst.

10. Vorrichtung zum Erkennen einer Störung in Bezug auf einen Anfangszustand, die wenigstens ein mechanisches Resonanzelement mit einem physikalischen Parameter umfasst, der für eine Störung nach einem der Ansprüche 7 bis 9 empfindlich ist, **dadurch gekennzeichnet, dass** das mechanische Resonanzelement ein Resonator des Balkentyps (P) ist, wobei die Anregungsquelle eine dem Resonator zugewandte Aktivierungselektrode ($E_A$) umfasst.

11. Vorrichtung zum Erkennen einer Störung in Bezug auf einen Anfangszustand, die wenigstens ein mechanisches Resonanzelement mit einem physikalischen Parameter umfasst, der für eine Störung nach Anspruch 10 empfindlich ist, **dadurch gekennzeichnet, dass** der Resonator ein Resonator des Balkentyps mit nanometrischen Abmessungen ist, wobei die Steuerelektrode das Anlegen von Spannungen in der Größenordnung von mehreren Volt zulässt, wobei der Spalt zwischen der Steuerelektrode und dem Resonator in der Größenordnung von mehreren hundert nm und beispielsweise zwischen 10 nm und 1 $\mu$m liegt.

12. Massesensor, der eine Vorrichtung nach einem der Ansprüche 7 bis 11 umfasst.

13. Gas- oder Partikeldetektor, der eine Vorrichtung nach einem der Ansprüche 7 bis 11 umfasst, zum Quantifizieren der Konzentration von vorhandenen Spezies, die in eine chemische Funktionalisierungsschicht absorbiert werden.

14. Massenspektrometer, das eine Vorrichtung nach einem der Ansprüche 7 bis 11 umfasst, zum Messen der Masse von jedem der auf der Vorrichtung platzierten Partikel.

**Claims**

1. A method for detecting a disturbance relative to an initial state in a device comprising at least one resonating mechanical element having a physical parameter that is sensitive to a disturbance such that said disturbance modifies the resonant frequency of said resonating mechanical element, said method comprising:

  - exciting said resonating mechanical element, which allows said resonating mechanical element to vibrate in a non-linear response domain in terms of amplitude at a variable vibration frequency,

  said amplitude and said frequency being linked by an initial function, said disturbance generating a measurement function;

  - detecting and analysing variations in amplitude of vibrations of said mechanical element between an amplitude of said initial function and an amplitude of the measurement function resulting from the excitation,

  **characterised in that** said initial function has a frequency, called bifurcation frequency $\Omega_{lim}$, that corresponds to a change in the growth and decay of the frequency as a function of the amplitude and has at least one unstable frequency band ($B_{INS}$), in which at least two stable amplitudes exist for the same frequency, and at least one stable frequency band ($B_S$), in which a single stable amplitude corresponds to a single frequency, said step of exciting said resonating mechanical element being carried out:

- by vibrating said mechanical element at the variable vibration frequency in a frequency band that is defined by a minimum frequency ($\Omega_{min}$) and a maximum frequency ($\Omega_{max}$); and
- according to at least one frequency cycle centred on a central frequency $\Omega_{op}$, with one of said minimum or maximum frequencies being located in the stable frequency band of said initial function, the other maximum or minimum frequency being located in the unstable frequency band.

2. The method for detecting a disturbance relative to an initial state according to claim 1, **characterised in that** said variable vibration frequency varies around a central frequency $\Omega_{op}$ according to the following rule: $\Omega(t)= \Omega_{op+} \delta\Omega$ Cos ($\varepsilon \pi t + \varphi$), with $\varepsilon$ being the frequency scanning speed, $\varphi$ being a value between 0 and $2\pi$ and $\Omega$ being said variable vibration frequency.

3. The method for detecting a disturbance relative to an initial state according to any one of claims 1 to 2, **characterised in that** said maximum frequency $\Omega_{max}$ is such that the factor as an absolute value: $|\Omega_{lim} - \Omega_{max)}|$ is between 0 and $10^{-1} \Omega_{op}$.

4. The method for detecting a disturbance relative to an initial state according to any one of claims 1 to 3, **characterised in that** it comprises a processing step for smoothing said central frequency $\Omega_{op}$ over time, so that said central frequency belongs to the frequency band defined by said minimum and maximum frequency.

5. The method for detecting a disturbance relative to an initial state according to any one of claims 1 to 4, **characterised in that** said physical parameter is the mass, with said minimum and maximum frequencies determining the thresholds of the largest mass and of the smallest mass to be detected.

6. The method for detecting a disturbance relative to an initial state according to any one of claims 1 to 5, **characterised in that** the frequency scanning speed $\varepsilon$ of a cycle is between approximately 1 Hz and 100 kHz or has a ratio $\varepsilon\pi/\Omega_{op}$, such that $0 < \varepsilon\pi/\Omega_{op} < 10^1$.

7. A device for detecting a disturbance relative to an initial state, comprising:

   - at least one resonating mechanical element (P) having a physical parameter that is sensitive to a disturbance such that said disturbance modifies the resonant frequency of said resonating mechanical element;
   - a source for exciting said resonating mechanical element, which allows said resonating mechanical element to vibrate in a non-linear response domain by amplitude at a variable vibration frequency,

   said amplitude and said frequency being linked by an initial function, said disturbance generating a measurement function;

   - means for detecting and analysing amplitude variations of vibrations of said mechanical element between an amplitude of said initial function and an amplitude of said measurement function,

   **characterised in that**:

   - said initial function has a frequency, called bifurcation frequency $\Omega_{lim}$, that corresponds to a change in the growth and decay of the frequency as a function of the amplitude and has at least one unstable frequency band ($B_{INS}$), in which at least two stable amplitudes exist for the same frequency, and at least one stable frequency band ($B_S$), in which a single stable amplitude corresponds to a single frequency;
   - said excitation source comprises means for varying said vibration frequency in a frequency band defined by a minimum frequency and a maximum frequency and according to at least one frequency cycle centred on a central frequency $\Omega_{op}$, with one of said minimum or maximum frequencies being located in the stable frequency band of said initial function, the other maximum or minimum frequency being located in the unstable frequency band.

8. The device for detecting a disturbance relative to an initial state comprising at least one resonating mechanical element having a physical parameter that is sensitive to a disturbance according to claim 7, **characterised in that** said excitation source comprises piezoelectric or thermo-elastic or magnetic or electrostatic or optical means.

9. The device for detecting a disturbance relative to an initial state comprising at least one resonating mechanical element having a physical parameter that is sensitive to a disturbance according to any one of claims 7 to 8, **characterised in that** said detection means comprise at least one transducer of the piezoresistive or capacitive or piezoelectric or optical or magnetic type.

10. The device for detecting a disturbance relative to an initial state comprising at least one resonating mechanical element having a physical parameter that is sensitive to a disturbance according to any one of claims 7 to 9, **characterised in that** said resonating mechanical element (P) is a resonator of the beam type, said excitation source comprising an activation electrode ($E_A$) facing said resonator.

11. The device for detecting a disturbance relative to an initial state comprising at least one resonating mechanical element having a physical parameter that is sensitive to a disturbance according to claim 10, **characterised in that** said resonator is a resonator of the type having a beam with nanometric dimensions, the control electrode allowing voltages of approximately several volts to be applied, the gap between said control electrode and said resonator being approximately several hundred nm and, for example, between 10 nm and 1 $\mu$m.

12. A mass sensor comprising a device according to any one of claims 7 to 11.

13. A gas or particle detector comprising a device according to any one of claims 7 to 11, for quantifying the concentration of species present that absorb into a chemical functionalisation layer.

14. A mass spectrometer comprising a device according to any one of claims 7 to 11, for measuring the mass of each of the particles placed on said device.

FIG.1

FIG.2

FIG.3

FIG.4

FIG.5

FIG.6a

FIG.6b

FIG.6c

FIG.7a

FIG.7b

FIG.8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description

- EP 2365282 A

- EP 2011065682 W

### Littérature non-brevet citée dans la description

- **N. KACEM ; S. HENTZ ; D. PINTO ; B. REIG ; V. NGUYEN.** Nonlinear dynamics of nanomechanical beam resonators: improving the performance of NEMS-based sensors. *Nanotechnology,* 2009, vol. 20, 275501
- **V. KAAJAKARI ; J. K. KOSKINEN ; T. MATTILA.** Phase noise in capacitively coupled micromechanical oscillators. *IEEE transactions on ultrasonics, ferroelectrics, and frequency control,* Décembre 2005, vol. 52 (12), 2322-31
- **W. ZHANG ; K. L. TURNER.** Application of parametric resonance amplification in a single-crystal silicon micro-oscillator based mass sensor. *Sensors and Actuators A: Physical,* Juillet 2005, vol. 122 (1), 23-30
- **DE M. 1. YOUNIS ; F. ALSALEEM.** Exploration of New Concepts for Structures Based on Nonlinear Phenomena. *Journal Of Computational And Nonlinear Dynamics,* 2009, vol. 4 (2), 021010
- **V. KUMAR ; S. MEMBER ; Y. YANG ; S. MEMBER ; G. T. CHIU ; J. F. RHOADS.** Modeling , Analysis , and Experimental Validation of a Bifurcation-Based Microsensor. *Journal of Microelectromechanical Systems,* 2012, vol. 21 (3), 549-558

- **KACEM et al.** Nonlinear dynamics of nanomechanical beam resonators: improving the performance of NEMS-based sensors. *Nanotechnology,* 2009, vol. 20, 275501
- **N. KACEM ; S.HENTZ ; D.PINTO ; B.REIG ; V.NGUYEN.** Nonlinear dynamics of nanomechanical beam resonators: improving the performance of NEMS-based sensors. *Nanotechnology,* 2009, vol. 20, 275501
- **CHASTE et al.** A nanomechanical mass sensor with yoctogram resolution. *Nature Nanotechnology,* 2012
- **V. GOUTTENOIRE ; T. BAROIS ; S. PERISANU ; J.-L. LECLERCQ ; S. T. PURCELL ; P. VINCENT ; A. AYARI.** Digital and FM demodulation of a doubly clamped single-walled carbon-nanotube oscillator: towards a nanotube cell phone. *Small (Weinheim an der Bergstrasse, Germany),* Mai 2010, vol. 6 (9), 1060-5
- **E. MILE ; G. JOURDAN ; I. BARGATIN ; S. LABARTHE ; C. MARCOUX ; P. ANDREUCCI ; S. HENTZ ; C. KHARRAT ; E. COLINET ; L. DURAFFOURG.** In-plane nanoelectromechanical resonators based on silicon nanowire piezoresistive detection. *Nanotechnology,* Avril 2010, vol. 21 (16), 165504